# EUROPÄISCHE PATENTANMELDUNG

(11) **EP 1 727 202 A2**
(43) Veröffentlichungstag der Anmeldung: **29.11.2006**
(21) Anmeldenummer: 06009282.2
(22) Anmeldetag: 05.05.2006
(51) Int. Cl.: H01L 25/075

(54) **Leuchtdioden-Anordnung**

(30) Priorität: 27.05.2005 DE 102005024830
(71) Anmelder: Noctron Holding S.A., 8140 Bridel (LU)
(72) Erfinder: Diamantidis, Georg, 56307 Dernbach (DE)
(74) Vertreter: Ostertag, Reinhard

(57) **Zusammenfassung**

Eine Leuchtdioden-Anordnung umfasst eine Mehrzahl von LED-Kristallstücken (12, 14, 16), welche durch Zuleitungen (22, 24) und Verbindungsleitungen (20) mechanisch gehaltert sind.

## Beschreibung

Die Erfindung betrifft eine Leuchtdioden-Anordnung gemäß dem Oberbegriff des Anspruches 1.

Einzelne Leuchtdioden sind sowohl in herkömmlicher Anschlußtechnik mit Anschlußfahnen als auch in Surface Mounted Technik bekannt.

Sie sind jeweils an einer ihrer Hauptfläche unmittelbar einer Platine benachbart und befinden sich in kleinen Gehäusen, die nur auf einer Seite lichtdurchlässig sind.

Auch Lot, welches sich platinenseitig auf der Begrenzungsfläche des LED-Kristallstückes einer Leuchtdiode befindet, verhindert ein Austreten von Licht an dieser Stelle.

Durch die vorliegende Erfindung soll eine Leuchtdioden-Anordnung gemäß dem Oberbegriff des Anspruches 1 so weitergebildet werden, daß eine bessere Lichtausbeute erhalten wird.

Diese Aufgabe ist erfindungsgemäß gelöst durch eine Leuchtdioden-Anordnung mit den im Anspruch 1 angegebenen Merkmalen.

Bei der erfindungsgemäßen Leuchtdioden-Anordnung ist das LED-Kristallstück von einer Trageinrichtung weitgehend freitragend gehalten. Licht kann somit, abgesehen von sehr kleinen Kontaktierungs-Befestigungsbereichen an allen Begrenzungsflächen des LED-Kristallstückes austreten.

Durch die Erfindung wird nicht nur eine höhere Lichtausbeute erzielt. Zugleich erhält man auch eine geringere Wärmeerzeugung und eine bessere Wärmeabfuhr.

Vorteilhafte Weiterbildung der Erfindung sind in Unteransprüchen angegeben.

Bei einer Leuchtdioden-Anordnung gemäß Anspruch 2 dienen die elektrischen Zuleitungen durch entsprechende Ausbildung zugleich als mechanische Trageinrichtung für die LED-Kristallstücke.

Bei einer Leuchtdioden-Anordnung gemäß Anspruch 3 werden die LED-Kristallstücke an ihren Rändern gehalten. Dies erlaubt es, die elektrischen Zuleitungen zu den LED-Kristallstücken mit sehr kleinem Durchmesser zu wählen, da sie keine mechanische Funktion zu erfüllen brauchen. Damit stellen die elektrischen Zuleitungen ihrerseits keine Abschattungen dar.

Die Weiterbildung der Erfindung gemäß Anspruch 4 ist im Hinblick auf die Schaffung einer ausgedehnten Lichtquelle mit im wesentlichen homogener Intensitiätsverteilung von Vorteil.

Aus dem gleichen Grunde ist auch die Weiterbildung der Erfindung gemäß Anspruch 5 besonders vorteilhaft.

Mit der Weiterbildung der Erfindung gemäß Anspruch 6 erhält man eine Leuchtdioden-Anordnung, die Licht in einem vorgegebenen Raumbereich gleich verteilt abgibt.

Bei einer Leuchtdioden-Anordnung gemäß Anspruch 7 sind die LED-Kristallstücke gegen Umwelteinflüsse geschützt.

Bei einer Leuchtdioden-Anordnung gemäß Anspruch 8 können die LED-Kristallstücke auch bei höherer Temperatur betrieben werden, ohne daß eine Verschlechterung ihrer Arbeitseigenschaften eintritt.

Den gleichen Vorteil erhält man bei einer Leuchtdioden-Anordnung gemäß Anspruch 9, wobei man zusätzlich den Vorteil einer guten Wärmeabfuhr von den LED-Kristallstücken hat, insbesondere wenn das Gehäuse mit einem leichten Edelgas wie Helium gefüllt ist.

Die Weiterbildung der Erfindung gemäß Anspruch 10 ist im Hinblick auf eine gleiche Orientierung der verschiedenen LED-Kristallstücke von Vorteil.

Die Weiterbildung der Erfindung gemäß Anspruch 11 ist im Hinblick auf gute Lichtdurchlässigkeit des Gehäuses und einfache Herstellbarkeit desselben von Vorteil.

Die Weiterbildung der Erfindung gemäß Anspruch 12 gestattet es, das von der Leuchtdioden-Anordnung abgegebene Licht noch zu bündeln oder zu streuen.

Mit der Weiterbildung der Erfindung gemäß Anspruch 13 wird erreicht, daß das von einer Leuchtdiode emittierte Licht nicht durch eine benachbarte Leuchtdiode abgeschattet wird. Vielmehr wird dieses Licht in eine Richtung umgelenkt, in welcher sich keine anderen LED-Kristallstücke befinden.

Spiegelflächen, wie sie im Anspruch 14 angegeben sind, lassen sich besonders einfach herstellen und sorgen für eine gute Umlenkung des von dem LED-Kristallstücken emittierten Lichts in eine zur Achse der Leuchtdioden-Anordnung senkrechte Richtung.

Die Weiterbildung der Erfindung gemäß Anspruch 15 ist im Hinblick auf einfache Montage der Lichtflächen und im Hinblick auf gleichförmige Umlenkung des aus den Stellflächen der LED-Kristallstücke austretenden Lichtstrahlen von Vorteil.

Die Weiterbildung der Erfindung gemäß Anspruch 16 ist im Hinblick auf eine einfache und sichere Positionierung der Spiegelflächen zusammen mit den LED-Kristallstücken von Vorteil.

Die Weiterbildung gemäß Anspruch 17 ist im Hinblick auf eine besonders einfache Kontaktierung der verschiedenen LED-Kristallstücke von Vorteil. Es wird auf diese Weise erreicht, daß die Trageinrichtung die Emission von Licht nur wenig behindert.

Auch die Weiterbildung der Erfindung gemäß Anspruch 18 ist im Hinblick auf ein einfaches Kontaktieren der LED-Kristallstücke von Vorteil.

Kristallstücke, wie sie im Anspruch 19 angegeben sind, lassen sich auf besonders einfache Weise realisieren und benötigen nur wenig Material.

Dabei zeichnet sich die Weiterbildung der Erfindung gemäß Anspruch 20 durch eine besonders hohe Lichtausbeute und ein für Nutzzwecke günstiges spektrales Verhalten der Leuchtdioden-Anordnung aus. Eine MQW (multi quantem well)-Schicht stellt eine Art Übergitter dar, welches für eine Verbreiterung des Emissionsspektrums sorgt.

Bei einer Leuchtdioden-Anordnung gemäß Anspruch 21 findet keine nennenswerte Abschattung emittierten Lichtes durch benachbarte LED-Kristallstücke statt.

Nachstehend wird die Erfindung anhand von Ausführungsbeispielen unter Bezugnahme auf die Zeichnung näher erläutert. In dieser zeigen:
- Figur 1: eine Leuchtdioden-Anordnung, welche drei durch Seilstücke gehaltene und mit Spannung beaufschlagte LED-Kristallstücke umfasst;
- Figur 2: eine ähnliche Ansicht wie Figur 1, wobei die Leuchtdioden-Anordnung in einem aus Glas gefertigten Gehäuse untergebracht ist;
- Figur 3: eine Aufsicht auf die Leuchtdioden-Anordnung nach Figur 2;
- Figur 4: eine ähnliche Ansicht wie Figur 1, wobei die Leuchtdioden-Anordnung vor einem konkaven Hohlspiegel angeordnet ist;
- Figur 5: eine ähnliche Ansicht wie Figur 2, wobei jedoch das die Leuchtdioden-Anordnung umgebende Gehäuse kugelförmig ausgebildet ist;
- Figur 6: eine Aufsicht auf eine kreisbogenförmige Leuchtdioden-Anordnung;
- Figur 7: einen axialen Schnitt durch eine dreidimensionale Leuchtdioden-Anordnung, die in einem krisidosenförmigen Gehäuse angeordnet ist;
- Figur 8: eine ähnliche Ansicht wie Figur 1, wobei jedoch die LED-Kristallstücke von einem rechenähnlichen Tragelement gehalten sind; und
- Figur 9: eine Aufsicht auf die Anordnung nach Figur 8;
- Figur 10: eine ähnliche Ansicht wie Figur 2, wobei jedoch innere Verbindungsleiter als Doppel-Spiegelkörper ausgebildet sind;
- Figur 11: eine ähnliche Ansicht wie Figur 10, wobei jedoch innere Verbindungsleiter als Einfach-Spiegelkörper ausgebildet sind;
- Figur 12: eine ähnliche Anordnung wie Figur 6, bei der jedoch bei den Innenseiten von LED-Krsitallstücken Spiegelkörper vorgesehen sind; und
- Figur 13: eine Aufsicht auf einen Teil einer abgewandelten Leuchtdioden-Anordnung mit mehreren LED-Kristallstücken, die senkrecht zur Zeichnungsebene hintereinander angeordnet sind und durch eine beim Rande vorgesehene Trageinrichtung gehalten sind.

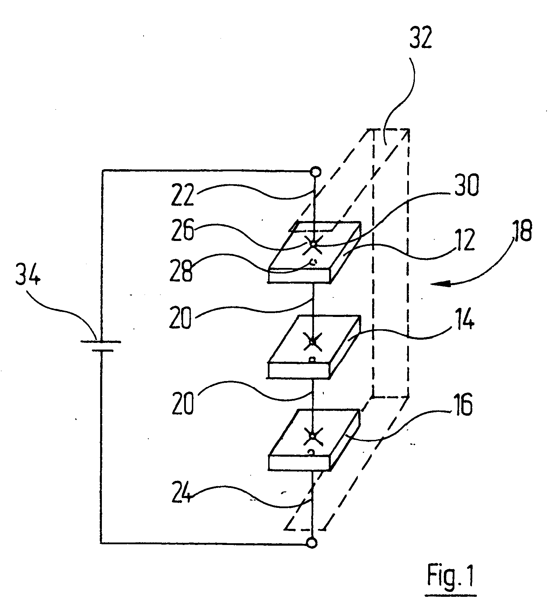

Figur 1 zeigt drei LED-Kristallstücke 12, 14, 16, die jeweils die Gestalt flacher Scheiben mit quadratischer Randkontur haben.

Jeder der LED-Kristalle ist aus einem entsprechend dotierten Wafer geschnitten, der eine p-dotierte Teilschicht und eine n-dotierte Teilschicht aufweist, so daß man an dem so erhaltenen p-n-Übergang durch Rekombination von Elektronen und Löchern Licht erhält.

Um sicherzustellen, daß in beliebiger Richtung aus den LED-Kristallstücken 12, 14, 16 austretendes Licht zur Nutzung bereitsteht, sind die LED-Kristallstücke 12, 14, 16 von einer insgesamt mit 18 bezeichneten Trageinrichtung so gehalten, daß ihre Begrenzungsflächen im wesentlichen frei liegen.

Hierzu sind die LED-Kristallstücke 12, 14, 16 unter einander durch Verbindungsleiter 20 verbunden, und die randständigen LED-Kristallstücke 12, 16 sind auf ihrer Außenseite jeweils mit einer Zuleitung 22 bzw. 24 versehen.

Die Verbindungsleiter 20 und die Zuleitungen 22, 24 können in der Praxis aus demselben Material gefertigt sein. Es kann sich z. B. um Drahtstücke aus Kupfer oder Silber, Litzen oder Seile aus Kupfer oder Silber oder dünne Stäbchen aus Kupfer oder Silber handeln. Dem Fachmann sind weitere elektrisch gut leitende reine,oder legierte Materialien bekannt, aus welchen die Verbindungsleiter 20 und die Zuleitungen 22, 24 gefertigt werden können.

Die Verbindung der Verbindungsleiter 20 bzw. der Zuleitungen 20, 22 mit den LED-Kristallstücken 12, 14, 16 erfolgt durch Lötungen 26, 28, die bei der Mitte der Oberseite bzw. Unterseite der LED-Kristallstücke vorgesehen sind. Diese Lötungen sind so ausgebildet, daß das Lot auf eine im wesentlichen kreisförmige Fläche 30 beschränkt bleibt, die verglichen mit den Kantenlängen der LED-Kristallstücke 12, 14, 16 nur kleinen Durchmesser aufweist.

Die gesamte in Figur 1 gezeigte Anordnung ist von einem U-förmigen Bügel 32 aus isolierendem Material getragen, der seinerseits auf nicht näher zu beschreibende Weise an einem Gerätegehäuse, einer Platine oder dgl. angebracht ist.

In betriebsbereitem Zustand sind die Zuleitungen 22, 24 mit einer Gleichspannungsquelle 34 verbunden.

Aus der obigen Beschreibung ist ersichtlich, daß die Leuchtdioden-Anordnung nach Figur 1 sehr einfachen mechanischen Aufbau aufweist, da die gleichen Komponenten für die elektrische Versorgung und die mechanische Halterung der LED-Kristallstücke genutzt werden. Dabei sind die LED-Kristallstücke 12, 14, 16 so gehalten, daß ihre Begrenzungsflächen praktisch völlig frei liegen.

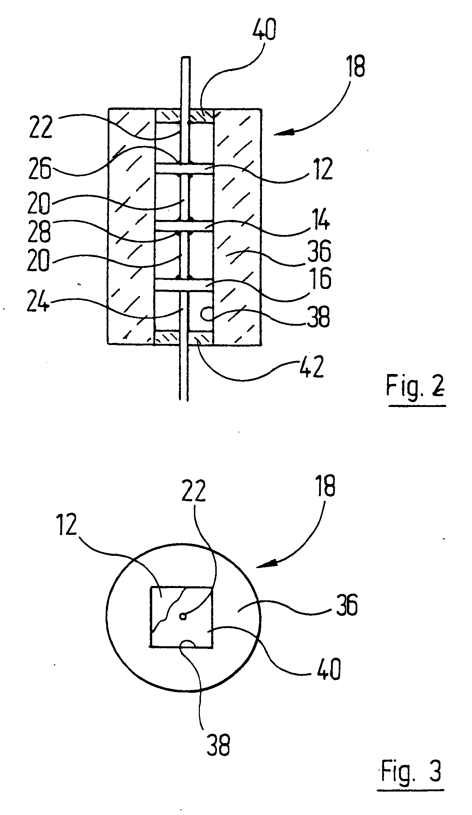

Beim Ausführungsbeispiel nach Figur 2 sind Komponenten, die unter Bezugnahme auf Figur 1 schon beschrieben wurden, wieder mit denselben Bezugszeichen versehen und werden nachstehend nicht nochmals detailliert beschrieben.

Anstelle des Bügels 32 dient zum Halten der LED-Kristallstücke 12, 14, 16 ein aus Glas gefertigtes Gehäuse 36. Dieses ist aus einem extrudierten Glasmaterial hergestellt, welches eine kreisförmige Außenkontur aufweist und einen quadratischen Innenquerschnitt aufweist. Der durch das Gehäuse 36 vorgegebene quadratische Innenraum 38 ist so bemessen, daß er der Randkontur der LED-Kristallstücke 12, 14, 16 entspricht, so daß letztere im Innenraum 38 in Winkelrichtung orientiert sind, also sich nicht bezüglich der durch die Zuleitungen 22, 24 und die Verbindungsleiter 20 vorgegebenen Achse der Anordnung verdrehen können.

Die Zuleitungen 22, 24 sind in Verschlußstopfen 40, 42 eingeschmolzen, die das obere bzw. untere Ende des Innenraumes 28 dicht verschließen.

Beim Ausführungsbeispiel nach Figur 2 kann somit der Bügel 32 entfallen, da das Gehäuse 36 die Zuleitungen 22, 24 hält.

Durch die oben beschriebene Außen- und Innenform des Gehäuses 36 wird nicht nur eine winkelmäßige Ausbuchtung der LED-Kristallstück 12, 14, 16 erhalten, man erhält zugleich auch eine Linsenwirkung durch vier plankonvexe Zylinderlinsen, welche durch das Gehäuse 36 gebildet sind.

Wünscht man eine solche Linsenwirkung nicht, kann man das Gehäuse 36 auch als Hülse mit quadratischem Querschnitt ausbilden, d. h. die vor den Seitenflächen der LED-Kristallstücke 12, 14, 16 liegenden Gehäuseabschnitte stehen dann planparallele Scheiben ohne Abbildungswirkung.

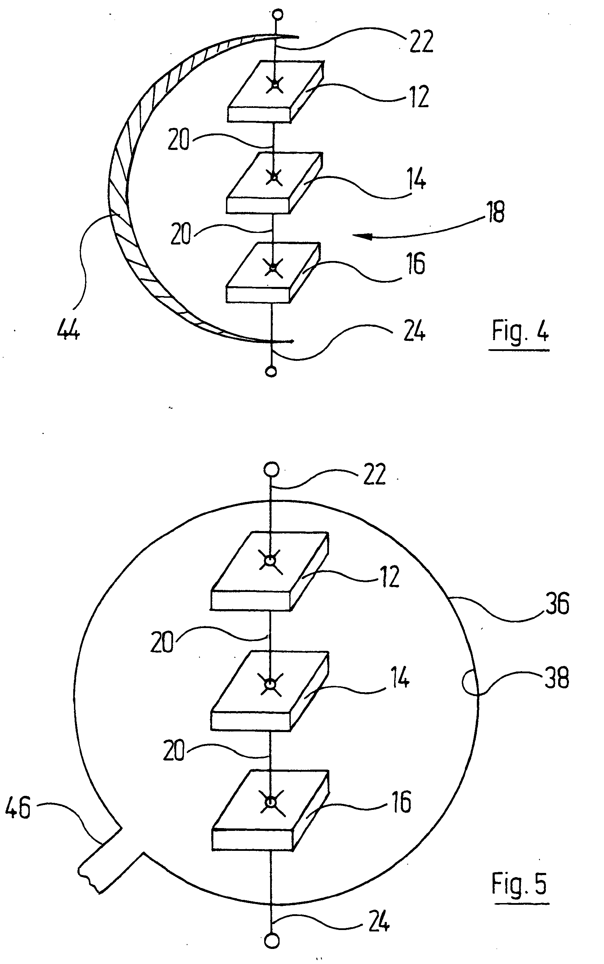

Figur 4 zeigt eine Leuchtdioden-Anordnung, wie sie unter Bezugnahme auf Figur 1 beschrieben wurde. Nur ist beim Ausführungsbeispiel nach Figur 4 der Bügel 32 als konkaver Hohlspiegel 44 ausgebildet. Man erhält somit wieder eine optische Wirkung, durch welche das von den LED-Kristallstücken 12, 14, 16 abgegebene Licht gebündelt wird.

Das Ausführungsbeispiel nach Figur 5 entspricht weitgehend demjenigen nach Figuren 2 und 3, nur ist das Gehäuse 36 als Kugel ausgebildet. In dieser sind jeweils die Zuleitungen 22, 24 wieder eingeschmolzen. Zusätzlich ist am Gehäuse 36 ein Stutzen 46 gezeigt, über welchen das Innere des Gehäuses 36 evakuiert und ggf. mit einem Inertgas gefüllt werden kann. Dabei wird nach dem Evakuieren und ggf. nach dem Füllen des Kugelinneren mit einem Inertgas der Stutzen 46 abgeschmolzen, so daß das Millieu im Inneren des Gehäuses 36 unveränderlich erhalten bleibt.

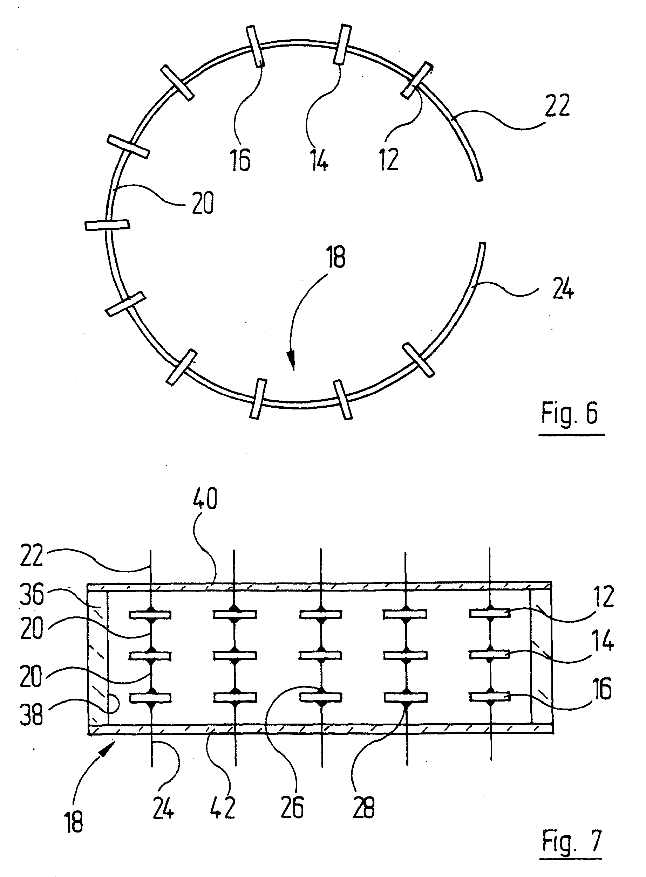

Beim Ausführungsbeispiel nach Figur 6 sind die LED-Kristallstücke 12, 14, 16 und weitere durch Verbindungsleiter 20 und Zuleitungen 22, 24 gehalten, die aus biegesteifen Drahtstücken bestehen. Auf diese Weise kann man erreichen, daß aufeinanderfolgende der LED-Kristallstücke 12, 14, 16 um einen gleichen Winkel gegeneinander verkippt sind.

Damit erhält man eine Gesamt-Strahlungscharakteristik der Leuchtdioden-Anordnung, die in der Ebene der Leuchtdioden-Anordnung vergleichmäßigt ist.

Es versteht sich, daß man in Abwandlung des Ausführungsbeispieles nach Figur 6 auch noch mehr LED-Kristallstücke vorsehen kann, so daß die gesamte Leuchtdioden-Anordnung einen Kreis bildet, wobei dann die Zuleitungen 22, 24 einander nahe benachbart in radialer Richtung vom Kreis weglaufen.

Beim Ausführungsbeispiel nach Figur 7 hat ein Gehäuse 36 die Form einer zylindrischen Dose mit planparallelen Deckplatten 40, 42. Diese halten nun eine Vielzahl von LED-Kristallstücken 12, 14, 16, die jeweils durch Verbindungsleiter 20 und Zuleitungen 22, 24 gehalten sind. Die gesamte Anordnung bildet somit eine ausgedehnte Lichtquelle mit im wesentlichen gleichbleibender Intensitätsverteilung.

In weiterer Abwandlung der Erfindung kann man auch andere räumliche Anordnungen der durch LED-Kristallstücke, Verbindungsleiter und Zuleitungen gebildeten Einheiten realisieren, z. B. indem man ein würfelförmiges transparentes Gehäuse verwendet und die durch Verbindungsleiter 20 und Zuleitungen 22, 24 vorgegebenen Achsen der einzelnen Leuchtdioden-Anordnungen unterschiedlich in x-Richtung, y-Richtung und z-Richtung in das würfelförmige Gehäuse einbaut. Man erhält so insgesamt eine Lichtquelle, die eine gut kugelförmige Intensitätsverteilung aufweist.

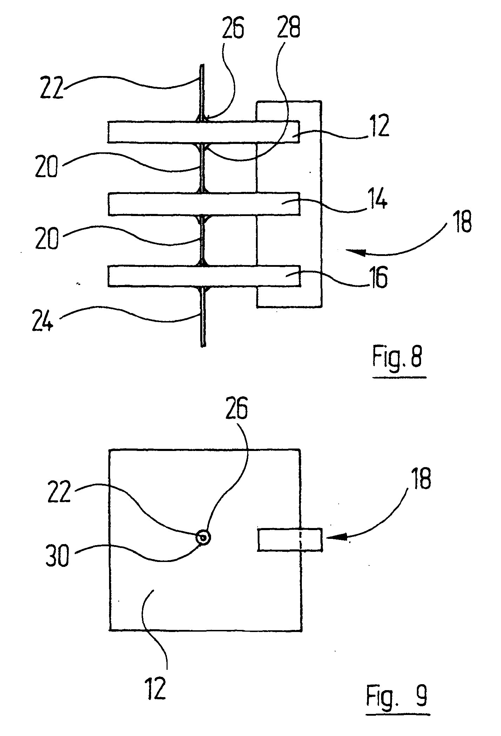

Beim Ausführungsbeispiel nach Figuren 8 und 9 ist die Trageinrichtung 18 rechenähnlich ausgebildet, und die LED-Kristallstücke 12, 14, 16 finden in den Zwischenräumen, die zwischen den Zinken des Rechens liegen, Aufnahme. Sie können dort im Preßsitz gehalten sein oder durch eine Glasfritte oder einen Klebstoff fest angebracht sein.

Die Zinken der Trageinrichtung 18 sind gerade so lang, wie dies zum sicheren Halten der LED-Kristallstücke 12, 14, 16 notwendig ist. Aus diesem Grunde sind auch beim Ausführungsbeispiel nach Figur 8 und 9 die Begrenzungsflächen der Kristallstücke im wesentlichen freiliegend.

Die Trageinrichtung 18 kann in der Praxis ein Glasformteil oder Kunststoff-Formteil sein, dessen Breite etwa ein Fünftel bis ein Drittel der Kantenlänge der LED-Kristallstücke beträgt.

In Abwandlung des Ausführungsbeispieles nach Figur 8 und 9 kann man die rechenähnliche Trageinrichtung 18 auch kreisbogenförmig oder in Form eines Ringes wählen, so daß man wieder die Vorteile einer winkelmäßigen Gleichverteilung der von der Leuchtdioden-Anordnung abgegebenen Intensität erhält.

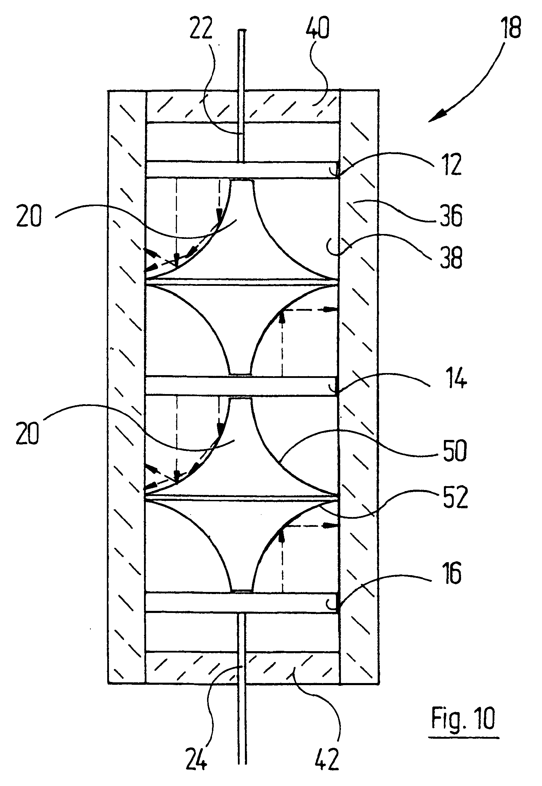

Bei den Ausführungsbeispielen nach den Figuren 10 bis 12 sind wiederum Komponenten, die obenstehend schon im Zusammenhang mit anderen Leuchtdioden-Anordnungen in funktionsäquivalenter Form beschrieben wurden, mit den selben Bezugszeichen versehen. Diese Komponenten werden nachstehend nicht nochmals detailliert beschrieben. Die Ausführungsformen nach den Figuren 10 bis 10 zeichnen sich dadurch aus, daß in der Nachbarschaft der Leuchtdioden Spiegelkörper vorgesehen sind, die rotationssymmetrische Spiegelflächen aufweisen, deren Achse im wesentlichen mit der Verbindungslinie aufeinanderfolgender Leuchtdioden fluchtet.

Beim Ausführungsbeispiel nach Figur 10 sind die sich zwischen benachbarten Leuchtdioden 12, 14, 16 erstreckenden Verbindungsleiter 20 als rotationssymmetrische Spiegelflächen aufweisende elektrische Leiter ausgebildet. Beim Ausführungsbeispiel nach Figur 10 hat der Verbindungsleiter 20 zwei mit ihren breiten Grundflächen aneinandergesetzte rotationssymmetrische Spiegelflächen 50, 52, die jeweils einen Teil eines Rotations-Hyperboloides darstellen.

Auf diese Weise strahlen die beiden Spiegelflächen 50, 52 Licht in im wesentlichen radialer Richtung ab, welches aus den Stirnflächen der Leuchtdioden 12, 14 usw. austritt.

Beim Ausführungsbeispiel nach Figur 10 hat die gemeinsame Basisfläche der beiden Spiegelflächen 50, 52 im wesentlichen den gleichen Durchmesser und die gleiche Randkontur wie die LED-Kristallstücke 12, 14, 16 und findet somit ebenfalls formschlüssig im Innenraum 38 des Gehäuses 36 Aufnahme.

Die Stirnflächen der Hyperboloid-Verbindungsleiter 20 können mit den Stirnflächen der benachbarten LED-Kristallstücke verlötet sein.

Man kann in Abwandlung aber auch den gesamten Stapel aus LED-Kristallstücken 12, 14, 16 und dazwischen geschachtelten Hyperboloid-Verbindungsleitern 20 unter elastische Vorspannung setzen, z. B. durch einen oder zwei federnde Kontakte, die am Stapelende angreifen und vom Gehäuse 36 gehalten sind.

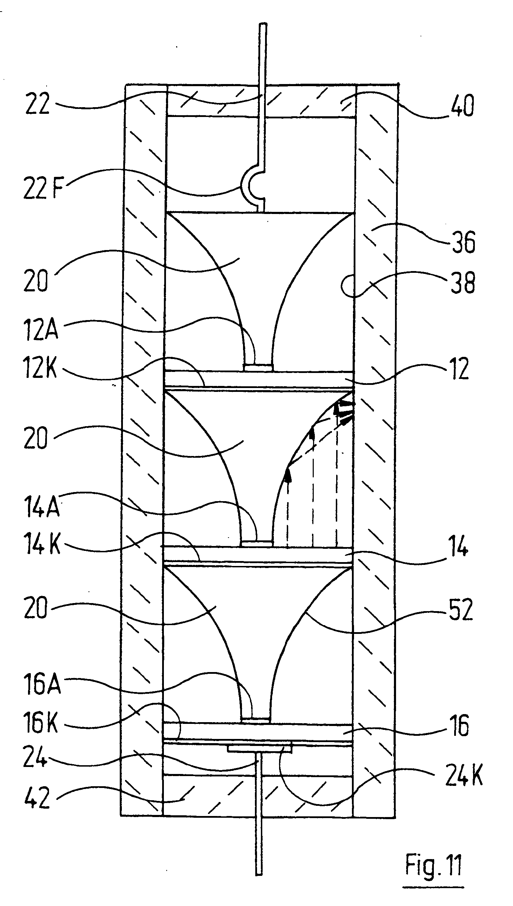

Eine solche Leuchtdioden-Anordnung ist in Figur 11 gezeigt. Bei ihr hat der Anschlußleiter 22 einen bügelfederartigen halbkreisförmigen Federabschnitt 22F, der Anschlußleiter 24 eine Kontaktplatte 24K.

In Figur 11 sind ferner Anodenkontakte der LED-Kristallsücke 12, 14, 16 mit 12A, 14A, 16A bezeichnet, Kathodenkontakte mit 12K, 14K, 16K.

Das Ausführungsbeispiel nach Figur 11 ähnelt im übrigen demjenigen nach Figur 10, nur hat man zwischen den aufeinanderfolgenden LED-Kristallstücken 12, 14, 16 Verbindungsleiter 20, die als Einfach-Rotationsparaboloid-Spiegelflächen ausgebildet sind.

Diese Anordnung wird in Verbindung mit solchen LED-Kristallstücken verwendet, die Licht nur nach einer Seite hin abstrahlen. Bei vielen marktüblichen LED-Kristallstücken ist es so, daß diese Licht nur im Bereich der Anode abgeben, während die Kathodenseite nicht lichtdurchlässig ist.

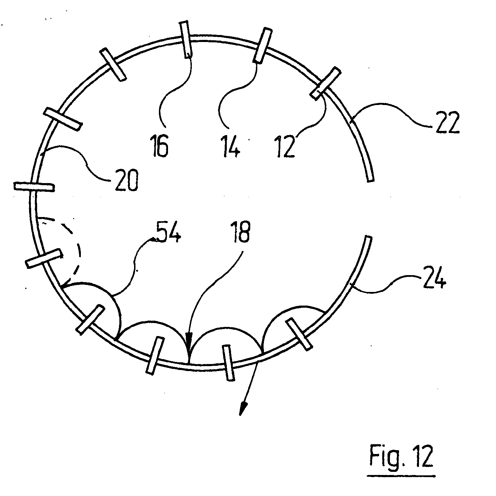

Beim Ausführugnsbeispiel nach Figur 12 sind auf die Verbindungsleiter 20 schalenförmige Spiegelkörper 54 aufgesetzt, die jeweils die Form eines Rotationsellipsoids haben. Durch diese Spiegelkörper 54 wird Licht, das von den LED-Kristallstücken 12, 14, 16 usw. in radialer Einwärtsrichtung abgegeben wird, in radiale Auswärtsrichtung umgelenkt.

Die Spiegelkörper 54 können auch als zusammenhängende Kette ausgebildet sein. Sie können auch die Form eines prismatischen Spiegelkörpers mit in axialer Richtung gleichbleibendem Querschnitt haben (parabolische Kanellierung).

Die Leuchtdioden-Anordnung gemäß Figur 12 erzeugt somit einen scheibenförmigen Lichtvorhang.

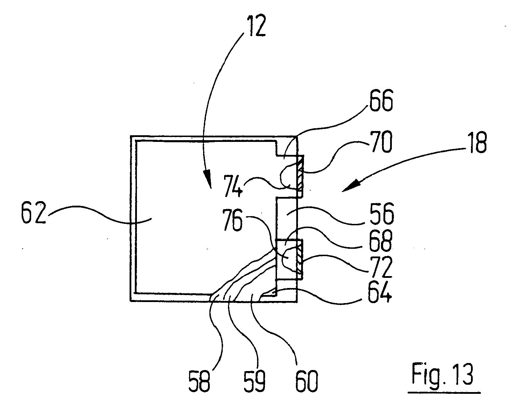

Bei dem in Figur 13 gezeigten weiteren Ausführungsbeispiel sind die LED-Kristallstücke 12 durch Verbundkörper gebildet. Diese sind bei ihrem in Figur 13 rechts gelegenen Rand mit der Trageinrichtung 18 verbunden.

Die LED-Kristallstücke 12 umfassen eine quadratische planparallele Substratplatte 56, die aus einem transparenten Glas hergestellt ist, insbesondere Saphirglas. Das Substratglas 56 trägt eine Mehrschichtstruktur, die folgende Schichten aufweist: eine p-leitende Schicht 58, eine hinter dieser liegende MQW-Schicht 59 und eine n-leitende Schicht 60. Auf der Oberseite der p-leitenden Schicht 58 ist eine erste Elektrodenschicht 62 vorgesehen, während die Unterseite der n-leitenden Schicht flächig mit einer zweiten Elektrodenschicht 64 in Verbindung steht, die von der Oberfläche des Substrates 56 getragen ist.

Die Elektrodenschichten 62, 64 haben in ihrem in Figur 13 rechts gelegenen Abschnitt Verbindungsfahnen 66, 68, die wie gezeigt gegeneinander versetzt sind.

Die Trageinrichtung 18 umfaßt zwei Anschlußbänder 70, 72 mit flachem rechteckigem Querschnitt, der jedoch so groß ist, daß die Anschlußbänder 70, 72 selbsttragend sind. Das Anschlußband 70 ist über eine Lötstelle 74 mit der Elektrodenschicht 62 verbunden, während das Anschlußband 72 über eine Lötstelle 76 mit der Elektrodenschicht 60 verbunden ist.

Die Schichten 58, 59, 60, 62 und 64 sind so dünn, daß die gesamte Mehrschichtstruktur für Licht durchlässig ist, welches durch Rekombination von Elektronen und Löchern in der Schichtstruktur 58, 59, 60 erzeugt wird.

Auf die in Figur 13 gezeigte Art und Weise kann man eine Vielzahl von Standard-LED-Kristallstücken auf einfache Weise mechanisch zu einer Reihe verbinden und zugleich elektrisch kontaktieren.

## Patentansprüche

1. Leuchtdioden-Anordnung mit mindestens einem LED-Kristallstück (12, 14, 16), und mit jeweils zwei Zuleitungen (22, 24) für ein LED-Kristallstück (12, 14, 16), über welche die LED-Kristallstücke (12, 14, 16) mit einer Spannungsquelle (34) verbindbar sind, **gekennzeichnet durch** eine Kristall-Trageinrichtung (18), welche die LED-Kristallstücke (12, 14, 16) so trägt, daß ihre Begrenzungsflächen zumindest in der Nachbarschaft des Licht emittierenden Kristallbereiches frei liegen.

2. Leuchtdioden-Anordnung nach Anspruch 1, **dadurch gekennzeichnet, daß** die Trageinrichtung (18) die Zuleitungen (20, 22, 24) umfasst, welche als Seilstücke, Drahtstücke oder dünne Stäbe ausgebildet sind.

3. Leuchtdioden-Anordnung nach Anspruch 1 oder 2, **dadurch gekennzeichnet, daß** die Trageinrichtung (18) ein mit den Umfangsrändern der LED-Kristallstücke (12, 14, 16) zusammenarbeitender starrer Körper ist, der vorzugsweise im wesentlichen die Gestalt eines Rechens mit vorzugsweise kurzen Zinken aufweist.

4. Leuchtdioden-Anordnung nach einem der Ansprüche 1 bis 3, **dadurch gekennzeichnet, daß** die Trageinrichtung 18) die LED-Kristallstücke (12, 14, 16) unter regelmäßigem Abstand voneinander trägt.

5. Leuchtdioden-Anordnung nach einem der Ansprüche 1 bis 4, **dadurch gekennzeichnet, daß** die Trageinrichtung (18) die LED-Kristallstücke (12, 14, 16) in im wesentlichen paralleler Ausrichtung trägt.

6. Leuchtdioden-Anordnung nach einem der Ansprüche 1 bis 5, **dadurch gekennzeichnet, daß** die Trageinrichtung (18) die LED-Kristallstücke (12, 14, 16) unter gleichförmiger relativer Verkippung aufeinanderfolgender LED-Kristallstücke (12, 14, 16) trägt.

7. Leuchtdioden-Anordnung nach einem der Ansprüche 1 bis 6, **dadurch gekennzeichnet, daß** die LED-Kristallstücke (12, 14, 16) und die Trageinrichtung (18) in einem transparenten Gehäuse (36) angeordnet sind.

8. Leuchtdioden-Anordnung nach Anspruch 7, **dadurch gekennzeichnet, daß** das Gehäuse (36) evakuiert ist.

9. Leuchtdioden-Anordnung nach Anspruch 7, **dadurch gekennzeichnet, daß** das Gehäuse (36) mit einem Inertgas gefüllt ist.

10. Leuchtdioden-Anordnung nach einem der Ansprüche 7 bis 9, **dadurch gekennzeichnet, daß** der lichte Querschnitt (38) des Gehäuses (36) der Außenkontur der LED-Kristallstücke (12, 14, 16) angepasst ist.

11. Leuchtdioden-Anordnung nach einem der Ansprüche 7 bis 10, **dadurch gekennzeichnet, daß** das Gehäuse (36) aus farblosem Glas oder farblosen Kunststoffmaterial hergestellt ist.

12. Leuchtdioden-Anordnung nach einem der ansprüche 1 bis 10, **dadurch gekennzeichnet, daß** die LED-Kristallstücke (12, 14, 16) hinter einer dispersen Optik (36) oder vor einer refraktiven Optik (44; 50, 52; 54) angeordnet sind.

13. Leuchtdioden-Anordnung nach einem der Ansprüche 1 bis 12, **dadurch gekennzeichnet, daß** in der Nachbarschaft der LED-Kristallstücke (12, 14, 16) Spiegelflächen (50, 52; 54) angeordnet sind.

14. Leuchtdioden-Anordnung nach Anspruch 13, **dadurch gekennzeichnet, daß** die Spiegelflächen (50, 52; 54) Rotationsflächen sind, insbesondere Rotations-Hyperboloide, Rotations-Paraboloide und Rotations-Ellipsoide.

15. Leuchtdioden-Anordnung nach Anspruch 13 oder 14, **dadurch gekennzeichnet, daß** die Achsen der Rotations-Spiegelflächen (50, 52; 54) im wesentlichen mit den Verbindungslinien aufeinanderfolgender LED-Kristallstücke (12, 14, 16) fluchten.

16. Leuchtdioden-Anordnung nach einem der Ansprüche 13 bis 15, **dadurch gekennzeichnet, daß** die Randkontur von als Spiegelflächen (50, 52) ausgebildeten Verbindungsleitern (20) der Randkontur der LED-Kristallstücke (12, 14, 16) entspricht und die Spiegelflächen (50, 52) so formschlüssig in einem die LED-Kristallstücke (12, 14, 16) aufnehmenden Gehäuse (36) positioniert sind.

17. Leuchtdiodenanordnung nach einem der Ansprüche 1 bis 16, **dadurch gekennzeichnet, daß** die Trageinrichtung 18 beim Rand der Kristallstücke (12) vorgesehen ist.

18. Leuchtdioden-Anordnung nach Anspruch 17, **dadurch gekennzeichnet, daß** die Trageinrichtung (18) zwei vorzugsweise rechteckigen Querschnitt aufweisende Zuleitungen (70, 74) umfaßt, welche isolierend über die Ränder der Kristallstücke 12 hinweggeführt sind und die jeweils mit einer von zwei Elektroden (62, 64) der Kristallstücke (12) verbunden sind.

19. Leuchtdioden-Anordnung nach einem der Ansprüche 1 bis 18, **dadurch gekennzeichnet, daß** die Kristallstücke (12) ein isolierendes Substrat (56) aufweisen, welches eine p-leitende Schicht (58), eine n-leitende Schicht (60) und diese Schichten kontaktierende Elektroden (60, 62) umfaßt.

20. Leuchtdioden-Anordnung nach Anspruch 19, **dadurch gekennzeichnet, daß** zwischen der p-leitenden Schicht (58) und der n-leitenden Schicht (60) eine MQW-Schicht (59) vorgesehen ist.

21. Leuchtdioden-Anordnung nach Anspruch 19 oder 20, **dadurch gekennzeichnet, daß** das isolierende Substrat (56) und die von ihm getragenen Schichten (58, 59, 60, 62, 64) für emittiertes Licht zumindest teilweise, vorzugsweise weitgehend durchlässig sind.
